# EUROPEAN PATENT APPLICATION

(11) **EP 4 797 537 A1**
(43) Date of publication of application: **26.08.2026**
(21) Application number: 26158986.5
(22) Date of filing: 17.02.2026
(51) Int. Cl.: H03M 1/12, H03M 1/18

(54) **UNDER-SAMPLING MIXED-SIGNAL APPARATUS FOR ADAPTATION OF HIGH-SPEED ANALOG FRONTENDS**

(30) Priority: 25.02.2025 US 202519062167
(71) Applicant: Avago Technologies International Sales Pte. Limited, Singapore 768923 (SG)
(72) Inventor: Kashmiri, Sayyed Mahdi, San Jose, 95118 (US); Hedayati, Hiva, San Jose, 95124 (US)
(74) Representative: Dilg, Haeusler, Schindelmann Patentanwaltsgesellschaft mbH

(57) **Abstract**

A mixed-signal unit including a sampler circuit and a tracking filter. The sampler circuit converts a code into a reference signal. In response to comparing an input signal to the reference signal, the sampler circuit produces a bitstream. Upon receiving the bitstream from the sampler circuit, the tracking filter updates the code using information contained in the bitstream. The tracking filter outputs the code to the sampler circuit in response to the tracking filter updating the code.

## Description

### BACKGROUND

Mixed-signal systems are electronic systems that process both analog and digital signals, combining the capabilities of analog and digital electronics in a single integrated platform. These systems are designed to interface with the real world, which is inherently analog, while leveraging the power and flexibility of digital processing. To manage analog inputs and perform digital processing, typical mixed-signal systems incorporate various specialized components.

Key components of mixed-signal systems include analog-to-digital converters (ADCs), which transform continuous analog signals into discrete digital representations that can be processed by digital circuits. Conversely, digital-to-analog converters (DACs) convert digital data back into analog signals for output or further analog processing. These converters function as bridges between the analog and digital domains, enabling seamless integration of both signal types within a single system.

Integrated circuits (ICs) play a crucial role in mixed-signal systems, often combining analog and digital circuitry on a single chip. These mixed-signal ICs may include amplifiers, filters, comparators, and other analog building blocks alongside digital logic, memory, and processing elements. By integrating these diverse functions, mixed-signal ICs can achieve higher performance, lower power consumption, and reduced system size compared to discrete implementations.

Other common components in mixed-signal systems may include sample- and-hold circuits, which capture instantaneous values of analog signals for conversion, and clock generators that provide timing signals for synchronizing various system operations. Additionally, mixed-signal systems often incorporate specialized digital signal processors (DSPs) optimized for efficient processing of digitized analog signals.

The ability to process both analog and digital signals makes mixed-signal systems essential in a wide range of applications, including telecommunications, audio and video processing, sensor interfaces, medical devices, and industrial control systems. As technology advances, the integration and performance of mixed-signal systems continue to improve, enabling more sophisticated and efficient electronic devices and systems.

### BRIEF DESCRIPTION OF DRAWINGS

The accompanying drawings, which form part of this specification, depict examples of the disclosure and, along with the description, illustrate the underlying principles of these examples. The detailed description is provided with reference to the accompanying figures. In the figures, the leading digit(s) of each reference number correspond to the figure where the reference number first appears. The figures may not be drawn to scale, and certain proportions or elements may be exaggerated in some figures to enhance the clarity of specific features.
FIG. 1 illustrates an exemplary mixed-signal system, in accordance with one or more embodiments of the disclosure.
FIG. 2 illustrates an exemplary block diagram, in accordance with one or more embodiments of the disclosure.
FIG. 3 illustrates an exemplary block diagram, in accordance with one or more embodiments of the disclosure.
FIG. 4 illustrates an exemplary timing diagram, in accordance with one or more embodiments of the disclosure.
FIG. 5 illustrates an exemplary filter group, in accordance with one or more embodiments of the disclosure.
FIGS. 6A-6E illustrate an exemplary analog input, in accordance with one or more embodiments of the disclosure.
FIG. 7 illustrates an exemplary calculation, in accordance with one or more embodiments of the disclosure.
FIG. 8 illustrates an exemplary VGA controller 245 and an exemplary DC compensator, in accordance with one or more embodiments of the disclosure.

In the drawings, like reference symbols and numerals indicate the same or similar components. Like elements in the various figures are denoted by like reference symbols and numerals for consistency. Identical or similar items across different figures are indicated by the same reference numbers. Unless otherwise indicated, like elements and method steps are referred to with like reference numerals.

### DETAILED DESCRIPTION OF THE INVENTION

The following describes technical solutions in this specification with reference to the accompanying drawings. Exemplary embodiments are described in detail with reference to the accompanying drawings.

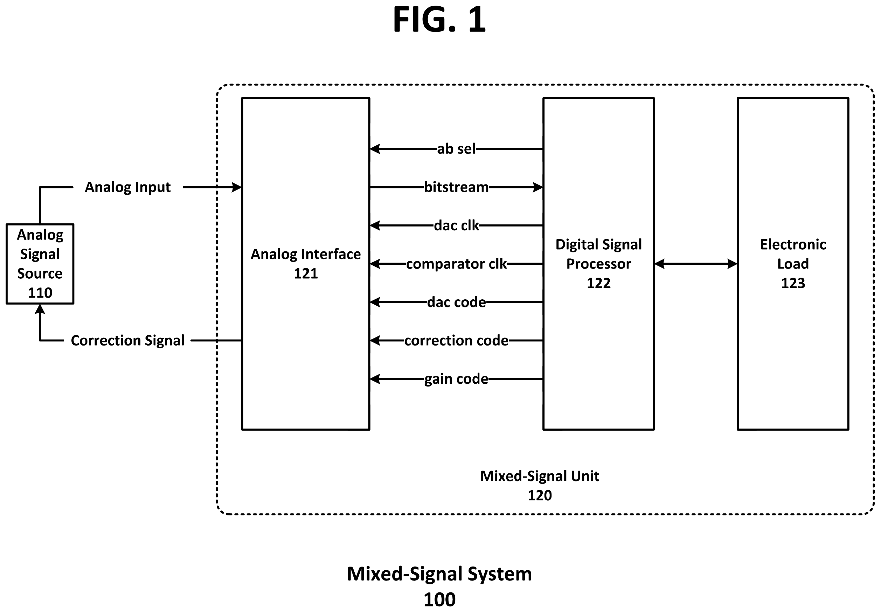

FIG. 1 illustrates an example mixed-signal system 100. In various implementations, mixed-signal system 100 may convert real-world analog input (such as sound, light, temperature, or RF waves) into digital data for further processing. Mixed-signal system 100 may include analog signal source 110 and mixed-signal unit 120. Those skilled in the art will appreciate there may be additional components in mixed-signal system 100.

Analog signal source 110 may be an electronic device or component that captures a real-world physical phenomenon. A real-world physical phenomenon, as referred to herein, is any event or change in the environment that a sensor can measure. The phenomenon may include light intensity, sound waves, temperature changes, pressure, motion, chemical properties and/or any other naturally occurring or measurable event or change in the environment. Examples of analog signal source 110 may include, but are not limited to, sensors, microphones, antennas, photodiodes, image sensors, transducers, function generators and/or any other electronic device or component that can convert a physical input into an analog electrical signal. Analog signal source 110 may convert the phenomenon into a corresponding analog input. The analog input may be a continuous-time, continuous-amplitude electrical signal based on the phenomenon.

Mixed-signal unit 120 may be configured as various types of electrically powered devices. For example, mixed-signal unit 120 may be configured as a mobile communication device such as a mobile phone, smartphone, cell phone, or tablet. Mixed-signal unit 120 may also be configured as a wearable device, smartwatch, fitness tracker or personal digital assistant (PDA). In other examples, mixed-signal unit 120 may be configured as a media device for playing and/or recording media. For instance, mixed-signal unit 120 may include a portable music player, audio recorder, audio converter, audio player, or speaker (e.g., a Bluetooth-enabled speaker). Mixed-signal unit 120 may also include video devices such as a video display, video recorder, camera, or other video device. In other examples, mixed-signal unit 120 may be configured as a driver assistance module in a vehicle, a light detection and ranging (LiDAR) sensor, an emergency transponder, a pager, a watch, a satellite television receiver, a stereo receiver, a computer system, music player, laptop or tablet computer, home appliance, or various other devices. Mixed-signal unit 120 may also be configured as a computing/entertainment device for a vehicle in some implementations.

Mixed-signal unit 120 is an apparatus that may include analog interface 121, digital signal processor 122 and electronic load 123. Electronic load 123 comprises circuitry designed to receive, process, exchange and utilize digital data with digital signal processor 122.

Those skilled in the art will appreciate that mixed-signal unit 120 may include additional components.

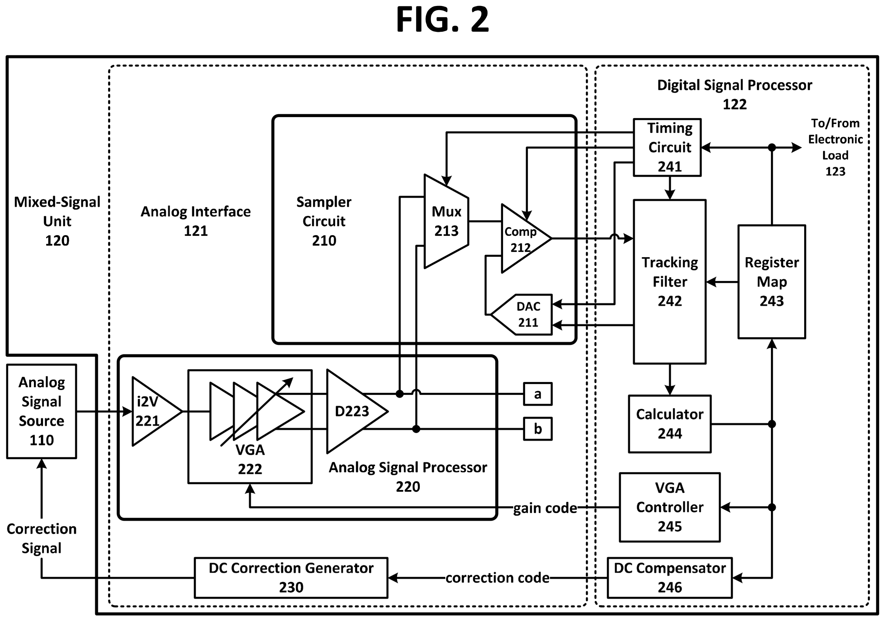

Figure 2 illustrates a block diagram of analog interface 121 and digital signal processor 122.

Analog interface 121 comprises electronic circuitry for processing and conditioning an analog input received from analog signal source 110. For example, analog interface 121 may improve signal integrity by performing functions such as minimizing noise, adjusting signal levels, and other operations to enable reliable signal processing by digital signal processor 122. In optical communication system implementations, analog interface 121 may include a transimpedance amplifier (TIA) to convert weak photodiode currents into usable voltage signals, followed by filters for noise suppression. In audio system implementations, analog interface 121 may include preamplifiers to boost low-level audio signals and bandpass filters to isolate specific frequency ranges. For radio-frequency (RF) communication systems, analog interface 121 may incorporate low-noise amplifiers (LNAs) to enhance weak RF signals from an antenna and filters to down-convert the RF signal to baseband. In medical device implementations like electrocardiogram machines, analog interface 121 may utilize instrumentation amplifiers to capture small biological signals and analog filters to eliminate interference.

As shown in Figure 2, analog interface 121 may include sampler circuit 210, analog signal processor 220 and DC correction generator 230. Sampler circuit 210 may comprise electronic hardware including digital-to-analog converter (DAC) 211, comparator 212 and multiplexer 213. Analog signal processor 220 may include current-to-voltage converter 221, variable gain amplifier 222 and driver 223. Those skilled in the art will appreciate that analog interface 121 may include additional components.

Digital signal processor 122 comprises electronic circuitry that converts an incoming bitstream from analog interface 121 into a DAC code, as will be explained in detail. Digital signal processor 122 may include timing circuit 241, tracking filter 242, register 243, calculator 244, VGA controller 245 and DC compensator 246.

Register 243 may store parameters for timing circuit 241, tracking filter 242, calculator 244, VGA controller 245 and DC compensator 246. These parameters serve as configuration settings that define the operational characteristics and behavior of each component. For timing circuit 241, the parameters may include clock frequencies, phase relationships, and timing intervals crucial for synchronizing various system operations. Tracking filter 242 parameters might encompass filter coefficients, integration time constants, and threshold values used in the proximity-weighted integration process. Calculator 244 may rely on parameters that define mathematical operations, scaling factors, and precision settings for computing real-time offset and amplitude signals. VGA controller 245 parameters could include gain thresholds, hysteresis bands, and scaling factors for amplitude adjustment decisions. Similarly, DC compensator 246 may utilize parameters such as offset setpoints, correction thresholds, and integration time constants to effectively manage DC offset correction. By centralizing these parameters in Register 243, the mixed-signal unit can maintain flexibility and adaptability, allowing for easy adjustment and optimization of system performance across different operating conditions or application requirements.

Register 243 may receive these parameters from electronic load 123. Those skilled in the art will appreciate that digital signal processor 122 may include additional components.

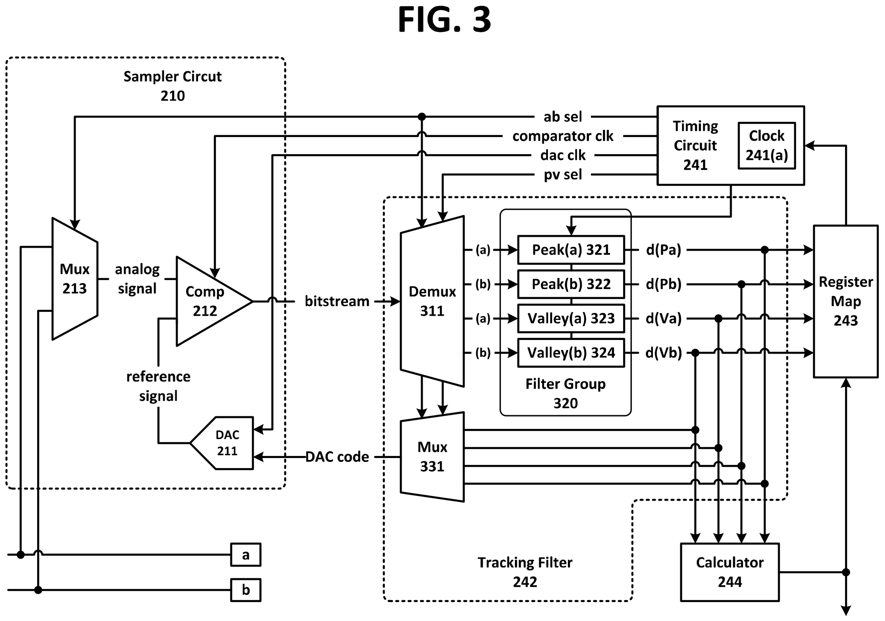

Turning now to FIG. 3, illustrated are sampler circuit 210, timing circuit 241, tracking filter 242, register 243 and calculator 244. Tracking filter 242 may include demultiplexer 311, filter group 320 and multiplexer 331.

Timing circuit 241 is electronic hardware that may produce multiple timing signals of specific frequencies, phases, durations and intervals to synchronize the operation of various components within mixed-signal unit 120. Timing circuit 241 may produce the timing signals from a reference clock 241(a). Timing circuit 241 is implemented as electronic hardware comprising digital circuits, analog circuits, or a hybrid of both. Analog circuits utilize components optimized for processing analog gate signals, while digital circuits employ switches and gates for handling digital gate signals.

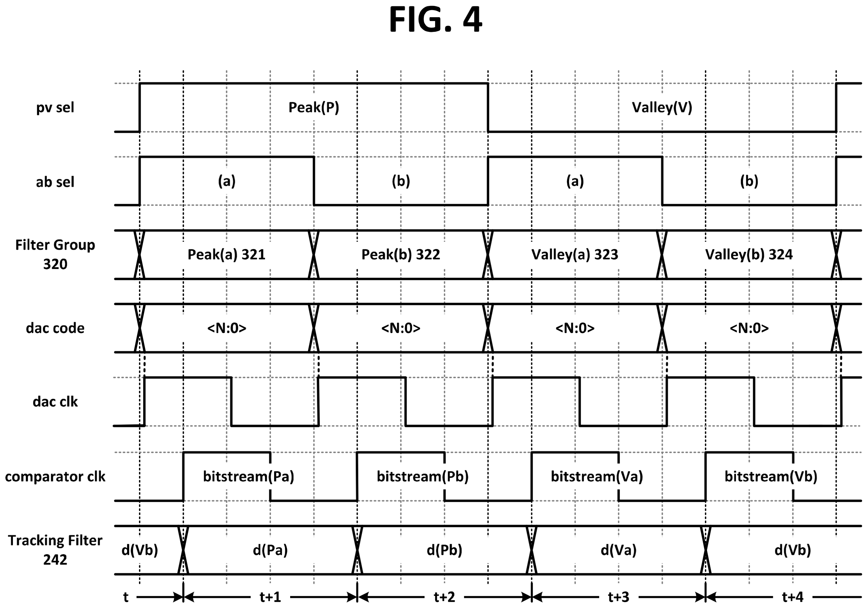

FIG. 4 illustrates an example timing diagram. While an implementation of timing that timing circuit 241 may generate is illustrated by the example of FIG. 4, those skilled in the art will appreciate that an alternative timing scheme generated by timing circuit 241 is within the scope of the invention.

DAC 211 may receive a DAC code from multiplexer 331 of tracking filter 242. The DAC code may comprise a digital word with a fixed bit length or fixed number of bits. By way of example, the digital word for the DAC code may "N" number of bits with "N" being an integer number. Referred to herein, a fixed number of bits is a predetermined and constant quantity of binary digits 1s and 0s. The fixed number may remain constant regardless of the specific value represented. Tracking filter 242 may update the DAC code based on information extracted from the bitstream that tracking filter 242 receives from sampler circuit 210, enabling adaptive tracking of the analog input's characteristics. This adaptive tracking mechanism allows the system to dynamically adjust to variations in the analog input signal. The tracking filter 242 performs proximity-weighted integration on the incoming bitstream, which involves assigning larger weights to data points closer to the reference envelope. This integration technique emphasizes the significance of data points near the envelope in the overall result.

The tracking filter 242 comprises multiple components, including peak tracking filters 321-322 and valley tracking filters 323-324, which process the bitstream to generate digital codes representing the peak and valley envelopes of the analog input. These digital codes, d(Pa), d(Pb), d(Va), and d(Vb), correspond to the peak and valley envelopes for both the non-inverted (a) and inverted (b) outputs of the analog input processor 220. By tracking both peaks and valleys for each differential output, the system maintains a comprehensive representation of the signal's behavior, enabling precise signal processing and adaptation in subsequent stages of the mixed-signal system.

The updated DAC code, output by the tracking filter 242 to the sampler circuit 210, serves as a feedback mechanism that continuously refines the reference signal used for comparison with the analog input. This feedback loop ensures that the system can adapt to changes in the analog input's amplitude, frequency, or other characteristics, maintaining optimal performance across varying input conditions.

DAC 211 may convert the DAC code into a reference signal. As used herein, the term "reference signal" refers to an analog signal generated when DAC 211 converts a digital code, such as the DAC code, into the reference signal. For instance, "reference signal" may refer to a signal generated by converting a digital code, such as the DAC code, into the reference signal for comparison against the input signal.

The reference signal serves as a comparison point against which an input signal is evaluated by comparator 212 to produce the bitstream. DAC 211 may dynamically adjust the reference signal based on updates to the DAC code provided by tracking filter 242, allowing mixed-signal unit 120 to adaptively track characteristics of the analog input such as the peak and valley envelopes.

Multiplexer 213 may receive a control signal (ab sel) from timing circuit 241. Based on the value of the control signal (ab sel), multiplexer 213 may select between a non-inverted signal (Va) and an inverted signal (Vb) and forward either the non-inverted signal (Va) or the inverted signal (Vb) to comparator 212 as an input signal. In some cases, the non-inverted signal (Va) may be 180 degrees out of phase from the inverted signal (Vb).

Comparator 212 may be a clocked, single-bit sign comparator. By way of example, comparator 212 may receive a comparator clk from timing circuit 241. The comparator clk is a clock signal that defines the specific points in time during which comparator 212 may sample the input signal, as illustrated by FIG. 4. In some implementations, comparator 212 may under-sample the input signal.

Under-sampling may refer to a signal processing technique where an analog input may be sampled at a rate below the Nyquist rate. Comparator 212 may receive the analog input in the form of an input signal. The Nyquist rate may typically be defined as twice the highest frequency component of the signal. This approach may intentionally violate the Nyquist-Shannon sampling theorem. The Nyquist-Shannon sampling theorem may state that to accurately reconstruct a signal, the sampling frequency should be at least twice the highest frequency component of the signal. In mixed-signal systems, under-sampling may be employed to capture sufficient information about the analog input's envelope or overall behavior without necessarily preserving all high-frequency details. This technique may be useful in applications where the full bandwidth of the signal may not be required or when hardware limitations may prevent sampling at the Nyquist rate. By sampling at a lower rate, under-sampling may reduce power consumption, simplify hardware requirements, and potentially decrease the amount of data that needs to be processed. However, under-sampling may introduce aliasing effects that may need to be carefully managed through appropriate filtering and signal processing techniques to extract the desired information from the under-sampled signal.

This approach may potentially introduce aliasing in the sampled data, but may be specifically designed to capture sufficient information to reconstruct key features of the analog input. In particular, under-sampling may preserve data points that may allow for the reconstruction of the analog input's peak envelope in some instances and the analog input's valley envelope in other instances. The peak envelope may represent the curve connecting the local maxima of the analog input over time. The valley envelope may connect the local minima of the analog input over time. By timing circuit 241 strategically selecting sampling points, mixed-signal unit 120 may perform under-sampling that may efficiently capture the overall shape and amplitude variations of the signal without the need for high-frequency sampling rates. Under-sampling may be particularly useful in mixed-signal systems where processing resources may be limited or where the primary interest may lie in tracking the signal's amplitude extremes rather than full waveform details.

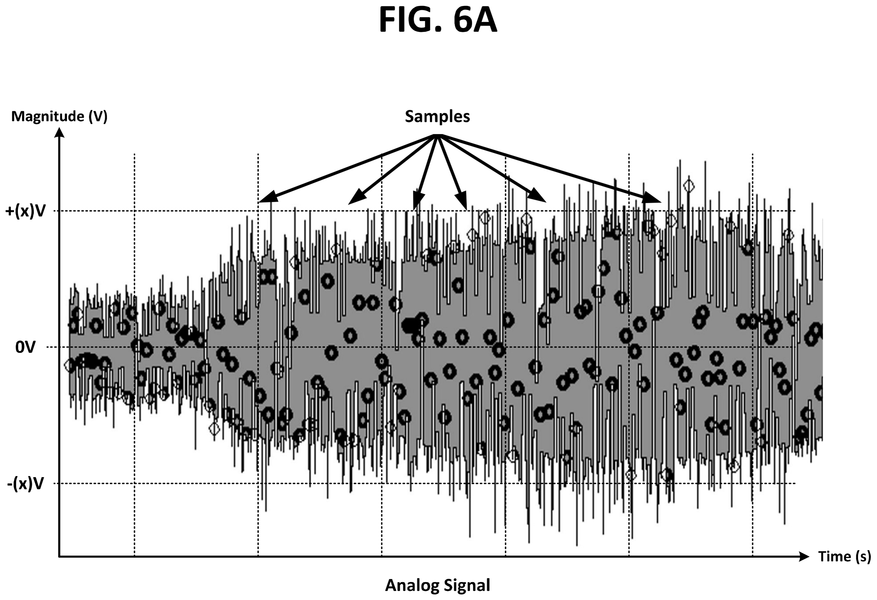

Comparator 212 may receive the analog input in the form of an input signal. In some implementations, comparator 212 may receive the reference signal from DAC 211 and the input signal from multiplexer 213. FIG. 6A is an example analog input in the time domain that comparator 212 may receive from multiplexer 213. When comparing the input signal to the reference signal, comparator 212 may sample the input signal at specific points in time, as illustrated by the darkened circles in FIG. 6A.

At the specific points in time defined by the comparator clock signal from timing circuit 241, comparator 212 may compare the input signal to the reference signal generated by DAC 211. The input signal may be either the non-inverted signal (Va) or the inverted signal (Vb) selected by multiplexer 213 based on the control signal (ab sel). In response to comparing the input signal to the reference signal, comparator 212 may produce a bitstream during a time slot. This bitstream is a stream of binary values, typically consisting of a single bit per sample, indicating whether the input signal amplitude is above or below the reference signal at each sampling point. The time slot represents a specific interval during which the comparator generates and outputs this bitstream, synchronizing with the overall timing scheme of the mixed-signal system. The resulting bitstream serves as a digital representation of the analog input signal's relationship to the reference signal, which is then processed by subsequent stages of the system, such as the tracking filter 242, to update the DAC code and adapt to changes in the input signal characteristics.

As used herein, the term "bitstream" refers to a sequence of binary digits (bits) that represents digital data. A data width of the bitstream may be a single bit. In the context of this invention, a bitstream specifically refers to the output produced by comparator 212 as a result of comparing the input signal to the reference signal. The bitstream may comprise data indicating whether the input signal exceeds or falls below the reference signal at particular sampling instances.

The reference signal may serve as a threshold for determining whether the input signal exceeds or falls below the reference signal at specific sampling instances. The term "exceeds" may refer to an instance where the amplitude or value of the input signal is greater than the amplitude or value of the reference signal at a particular sampling point in time. The term "falls below" may refer to an instance where the amplitude or value of the input signal is less than or equal to the amplitude or value of the reference signal at a particular sampling point in time.

The term "sampling instance" may refer to a discrete point in time at which the sampler circuit compares the input signal to the reference signal, as determined by a clock signal provided to the sampler circuit. These sampling instances may occur at regular intervals or according to a predetermined sampling scheme.

Each bit in the bitstream may have a value of 0 or 1, indicating the result of the comparison at a particular instant. The bitstream serves as input to the tracking filter 242 for further processing and updating of the DAC code used to generate the reference signal.

FIG. 4 illustrates bitstream(Pa) during time slot (t+1), bitstream(Pb) during time slot (t+2), bitstream(Va) during time slot (t+3) and bitstream(Vb) during time slot (t+4). Existing as a stream of binary values, the bitstream may indicate whether the input signal is above the reference signal. For example, the bitstream may be of a value indicating that the input signal is above the reference signal in some instances. In other instances, the bitstream may be of a value indicating that the input signal is equal to or below the reference signal.

Tracking filter 242 may receive the bitstream from comparator 212 during the time slot, as illustrated in FIG. 4. Upon receiving the bitstream, tracking filter 242 may update the DAC code using information contained in the bitstream. For instance, tracking filter 242 may perform proximity-weighted integration on the incoming bitstream. Integration is the summing of discrete data points to approximate the area under a curve. Referring to herein, proximity-weighted integration is an integration technique in which data points in a bitstream are assigned larger weights based on their proximity to a reference envelope, emphasizing their significance in the overall result of the integration.

As an example, FIG. 3 illustrates filter group 320 that includes peak tracking filters 321-322 and valley tracking filters 323-324. Demultiplexer 311 may receive the control signal (ab sel) and a control signal (pv sel) from timing circuit 241. Based on the values of the control signal (ab sel) and control signal (pv sel), demultiplexer 311 may route the bitstream to one of the four tracking filters 321-324 as bitstreams (a, b, a, b) in a manner illustrated in FIG. 4.

The result of the proximity-weighted integration performed by the peak tracking filters 321-322 and valley tracking filters 323-324 are digital codes that represent two peaks and two valleys for the two fully differential output terminals of the transimpedance amplifier (TIA). Specifically, these digital codes are binary words d(Pa), d(Pb), d(Va), and d(Vb), which correspond to the peak and valley envelopes of the analog input for both the non-inverted (a) and inverted (b) outputs of analog signal processor 220. These digital codes may be useful for capturing the dynamic range and characteristics of the analog input in a fully differential configuration. By tracking both peaks and valleys for each differential output, the system may maintain a comprehensive representation of the signal's behavior, potentially enabling precise signal processing and adaptation in subsequent stages of the mixed-signal system.

The peak tracking filters 321-322 generate binary words d(Pa) and d(Pb), which numerically represent the amplitudes of the peak envelopes for the non-inverted and inverted signals, respectively. Similarly, the valley tracking filters 323-324 produce binary words d(Va) and d(Vb), representing the amplitudes of the valley envelopes for the non-inverted and inverted signals. Peak tracking filters 321-322 and valley tracking filters 323-324 are depicted as modular circuits in FIG. 4. As referred to herein, modular circuits are circuits that each have identical functionality, design, and/or layout.

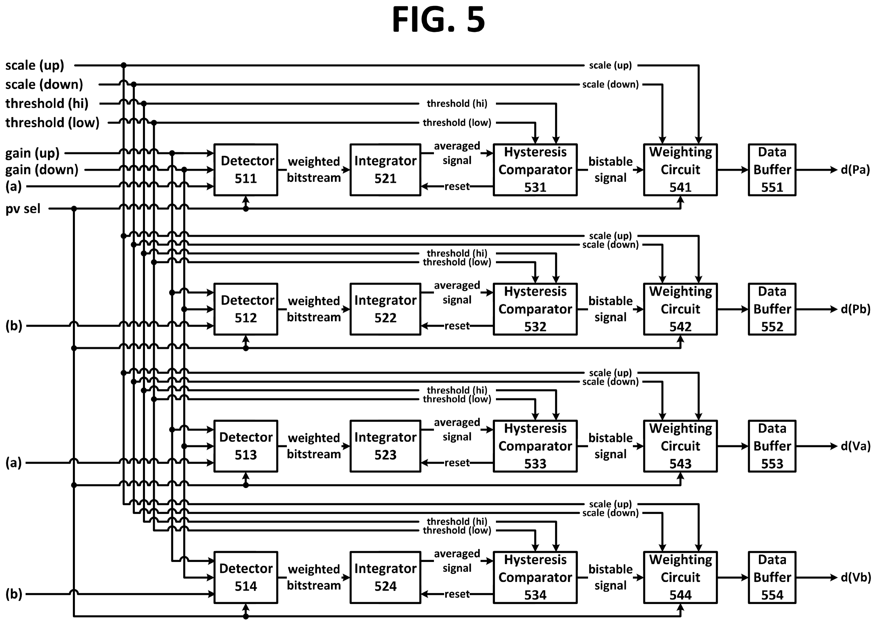

An example filter group 320 is illustrated in FIG. 5. For instance, peak tracking filter 321 may include detector 511, integrator 521, hysteresis comparator 531, weighting circuit 541 and data buffer 551. Peak tracking filter 322 may include detector 512, integrator 522, hysteresis comparator 532, weighting circuit 542 and data buffer 552. Valley tracking filter 323 may include detector 513, integrator 523, hysteresis comparator 533, weighting circuit 543 and data buffer 553. Valley tracking filter 324 may include detector 514, integrator 524, hysteresis comparator 534, weighting circuit 544 and data buffer 554. Those skilled in the art will appreciate there may be additional components in filter group 320.

Any one of detectors 511-514 may be individually referred to herein as "detector." Detectors 511-514 may be collectively referred to herein as "detectors." Any one of integrators 521-542 may be individually referred to herein as "integrator." Integrators 521-542 may be collectively referred to herein as "integrators."

Any one of hysteresis comparators 531-534 may be individually referred to herein as "hysteresis comparator." Hysteresis comparators 531-534 may be collectively referred to herein as "hysteresis comparators."

Any one of weighting circuits 541-544 may be individually referred to herein as "weighting circuit." Weighting circuits 541-544 may be collectively referred to herein as "weighting circuits."

Any one of data buffers 551-554 may be individually referred to herein as "data buffer." Data buffers 551-554 may be collectively referred to herein as "data buffers."

Demultiplexer 311 may route bitstream (a) to detector 511, bitstream (b) to detector 512, bitstream (a) to detector 513, and bitstream (b) to detector 514. Control signal (pv sel) may be a two-level binary signal that alternates between two distinct states - a peak state and a valley state. The peak state may correspond to one logic level, while the valley state may correspond to another logic level. When control signal (pv sel) is at the peak state, a detector may function as a peak detector. Conversely, when control signal (pv sel) is at the valley state, a detector may function as a valley detector.

The detector may be an electronic circuit that applies asymmetric weighting to the bitstream, transforming it into a weighted bitstream. Asymmetric weighting involves assigning unequal significance or weight to different bits in the bitstream. To apply asymmetric weighting, the detector may assign varying levels of significance to specific bits. The detector may receive a gain (up) signal and a gain (down) signal.

When functioning as a peak detector, the gain (up) signal may be a scaling factor larger than the gain (down) signal. The peak detector may introduce asymmetric weighting by applying the scaling factor of the gain (up) signal to the bitstream. Conversely, when functioning as a valley detector, the gain (down) signal may be a scaling factor larger than the gain (up) signal. The valley detector may introduce asymmetric weighting by applying the scaling factor of the gain (down) signal to the bitstream. Through this asymmetric weighting, the detector may convert the bitstream into a weighted bitstream.

The integrator may be an electronic circuit that receives and accumulates the digital bits in the weighted bitstream. After accumulating the digital bits, the integrator may smooth the weighted bitstream by continuously averaging the digital bits over time to reduce fluctuations. This averaging process may convert the weighted bitstream into an averaged signal.

The hysteresis comparator may be an electronic circuit that converts the averaged signal into a bistable signal. The bistable signal may have only two states: a high threshold state and a low threshold state. The hysteresis comparator may compare the averaged signal against threshold (hi) and threshold (low) signals. If the averaged signal exceeds threshold (hi), the hysteresis comparator may set the bistable signal to the high threshold state and trigger a reset of the integrator. Similarly, if the averaged signal falls below threshold (low), the hysteresis comparator may set the bistable signal to the low threshold state and trigger a reset of the integrator.

The weighting circuit may be an electronic circuit that applies asymmetric weighting to the bistable signal, transforming it into an error signal. To apply asymmetric weighting, the weighting circuit may assign varying levels of significance to the states in the bistable signal. The weighting circuit may receive a scale (up) signal and a scale (down) signal.

When the detector functions as a peak detector, the scale (up) signal may be a scaling factor larger than the scale (down) signal. The weighting circuit may introduce asymmetric weighting to the bistable signal by applying the scaling factor of the scale (up) signal. Conversely, when the detector functions as a valley detector, the scale (down) signal may be a scaling factor larger than the scale (up) signal. The weighting circuit may introduce asymmetric weighting to the bistable signal by applying the scaling factor of the scale (down) signal. By asymmetrically weighting the bistable signal, the weighting circuit may convert it into a signal that feeds the data buffer.

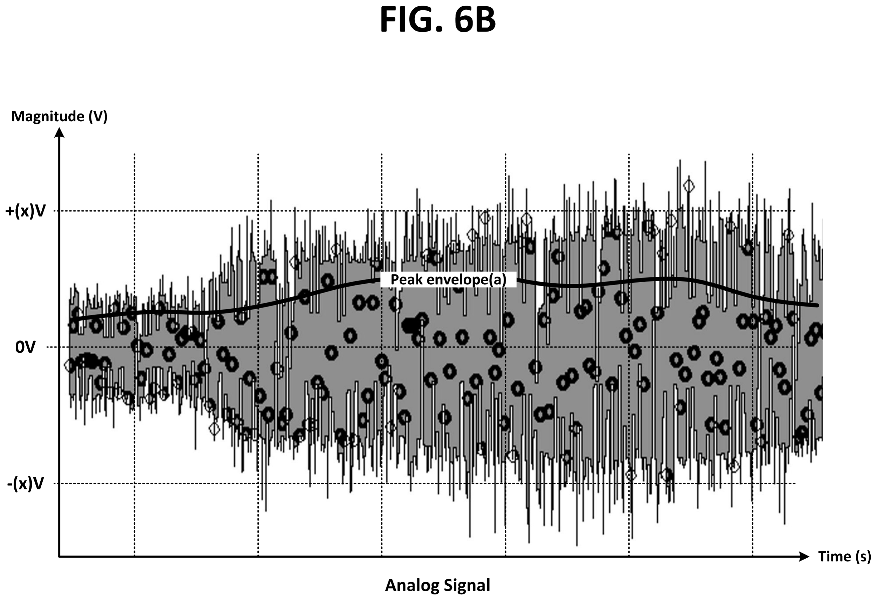

FIG. 6B illustrates peak envelope(a) of the analog input in the time domain. Binary word d(Pa) from peak tracking filter 321 may represent an amplitude of peak envelop(a) at the transition from time slot (t) to time slot (t+1). Peak envelope(a) may be a smooth curve that traces the maximum amplitude values of the analog input over time. Peak tracking filter 321 may perform proximity-weighted integration on bitstream(Pa) to produce peak envelope(a) during time slot (t+1). Peak envelope(a) may provide a representation of how the amplitude of the analog input varies without considering rapid oscillations or high-frequency components. During time slot (t+1), peak tracking filter 321 may update the digital value of binary word d(Pa) with a numerical representation of the amplitude of peak envelop(a).

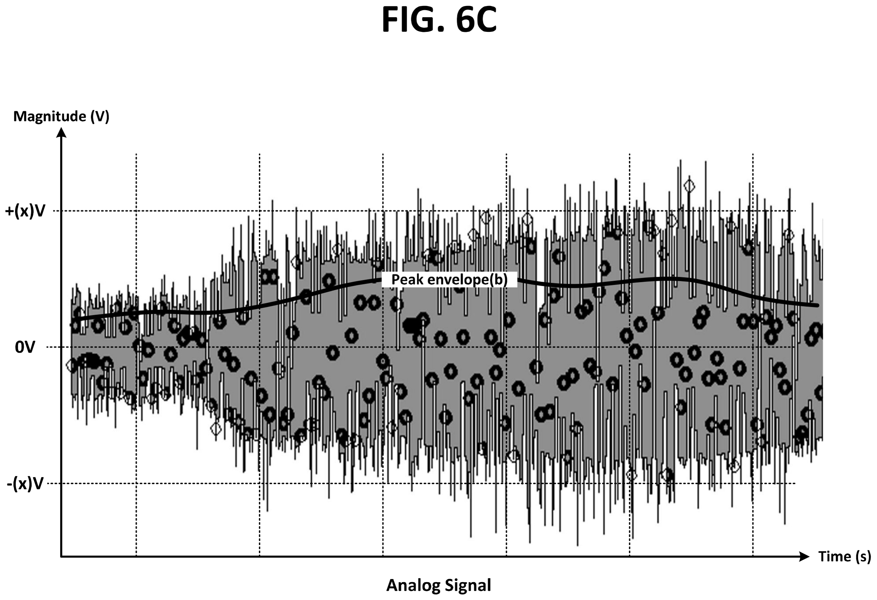

FIG. 6C illustrates peak envelope(b) of the analog input in the time domain. Binary word d(Pb) from peak tracking filter 322 may represent an amplitude of peak envelop(b) at the transition from time slot (t+1) to time slot (t+2). Peak envelope(b) may be a smooth curve that traces the maximum amplitude values of the analog input over time. Peak tracking filter 322 may perform proximity-weighted integration on bitstream(Pb) to produce peak envelope(b) during time slot (t+2). Peak envelope(b) may provide a representation of how the amplitude of the analog input varies without considering rapid oscillations or high-frequency components. During time slot (t+2), peak tracking filter 322 may update the digital value of binary word d(Pb) with a numerical representation of the amplitude of peak envelop(b).

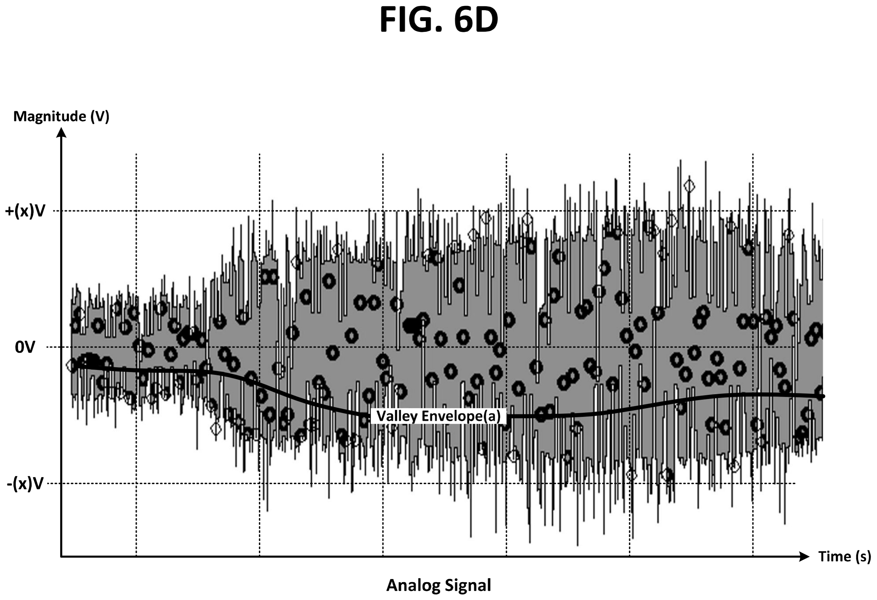

FIG. 6D illustrates valley envelope(a) of the analog input in the time domain. Binary word d(Va) from valley tracking filter 323 may represent an amplitude of valley envelop(a) at the transition from time slot (t+2) to time slot (t+3). Valley envelope(a) may be a smooth curve that traces the minimum amplitude values of the analog input over time. Valley tracking filter 323 may perform proximity-weighted integration on bitstream(Va) to produce valley envelope(a) during time slot (t+3). Valley envelope(a) may provide a representation of how the amplitude of the analog input varies without considering rapid oscillations or high-frequency components. During time slot (t+3), valley tracking filter 323 may update the digital value of binary word d(Va) with a numerical representation of the amplitude of valley envelop(a).

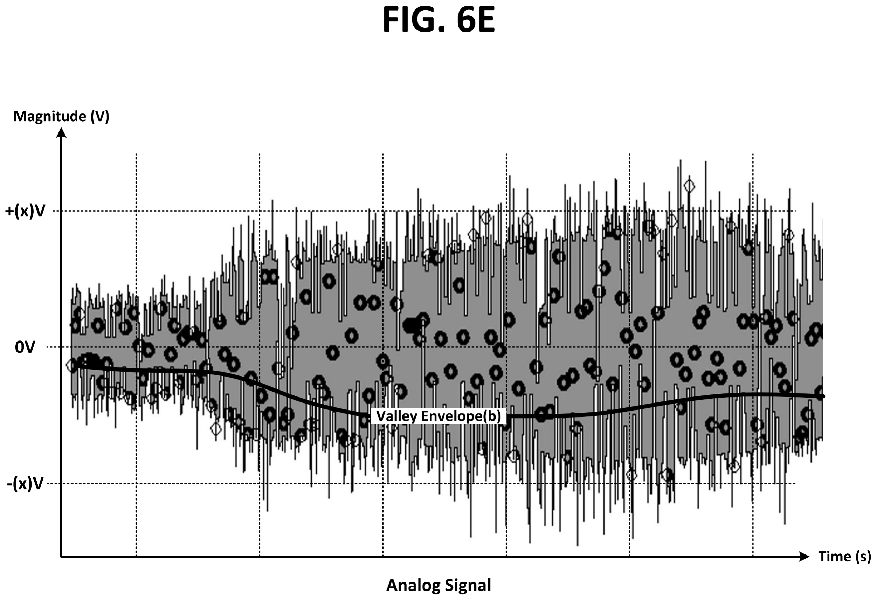

FIG. 6E illustrates valley envelope(b) of the analog input in the time domain. Binary word d(Vb) from valley tracking filter 321 may represent an amplitude of valley envelop(b) at the transition from time slot (t+3) to time slot (t+4). Valley envelope(b) may be a smooth curve that traces the minimum amplitude values of the analog input over time. Valley tracking filter 321 may perform proximity-weighted integration on bitstream(Vb) to produce valley envelope(b) during time slot (t+4). Valley envelope(b) may provide a representation of how the amplitude of the analog input varies without considering rapid oscillations or high-frequency components. During time slot (t+4), valley tracking filter 321 may update the digital value of binary word d(Vb) with a numerical representation of the amplitude of valley envelop(b).

Tracking filter 242 may output the DAC code to DAC 211. For example, multiplexer 331 may receive a control signal (pv sel) from timing circuit 241. Based on the value of the control signal (pv sel), multiplexer 331 may select between binary words d(Pa), d(Pb), d(Va) and d(Vb). Upon selection, multiplexer 331 may forward the chosen binary word to DAC 211 as the DAC code.

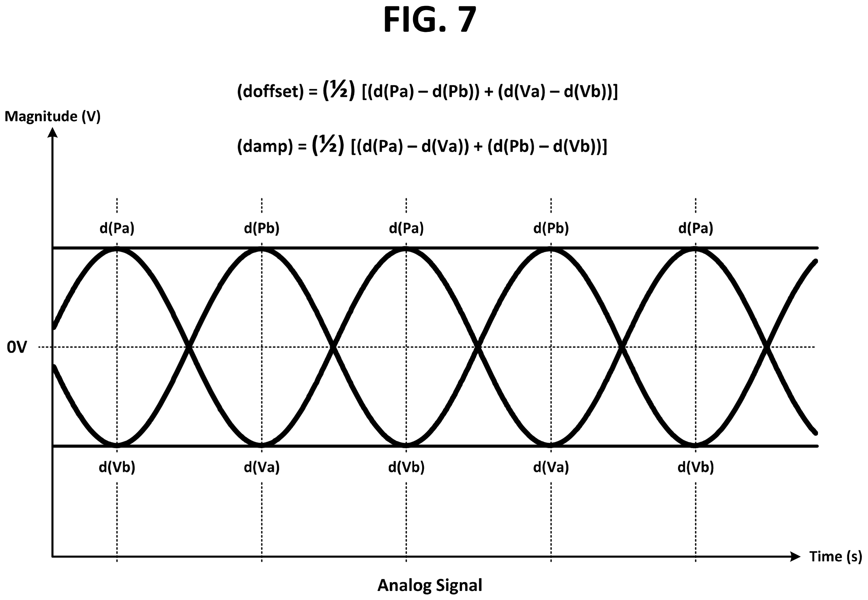

FIG. 7 illustrates an example calculation that calculator 244 may perform to produce real-time offset (doffset) and real-time the amplitude (damp) signal. Calculator 244 may receive d(Pa), d(Pb), d(Va) and d(Vb) from tracking filter 242. Upon receiving these values, calculator 244 may calculate real-time offset (doffset) and real-time the amplitude (damp) signal. In the example shown in FIG. 7, d(Pa) may be 180 degrees out of phase from d(Vb), while d(Pb) may be 180 degrees out of phase from d(Va). Real-time offset (doffset) may be a digital word of "L" number of bits, where "L" is an integer. Real-time the amplitude (damp) signal may be a digital word of "M" number of bits, where "M" is another integer. Calculating offset (doffset) and the amplitude (damp) signal in real-time may allow digital signal processor 122 to adapt effectively to variations in the analog input.

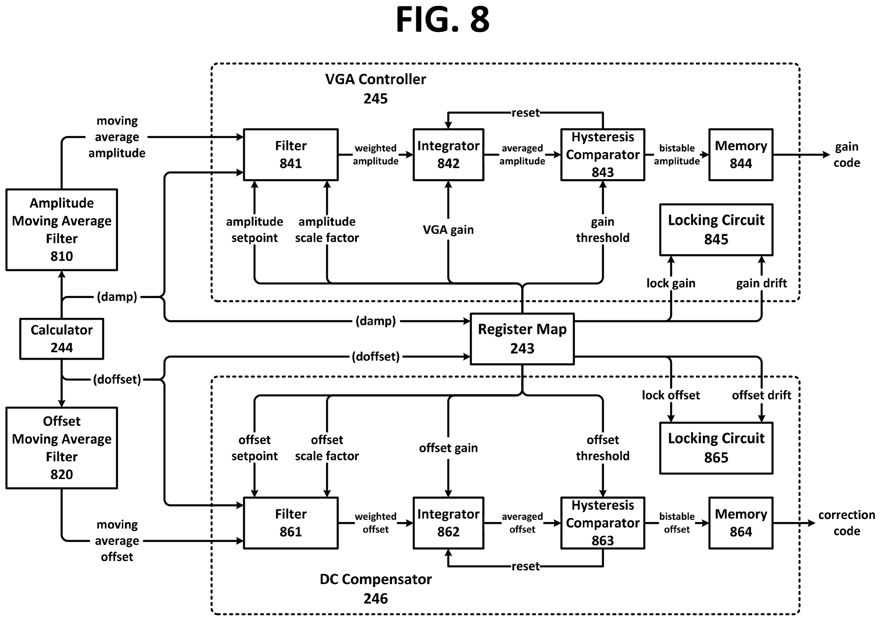

Turning now to FIG. 8, illustrated are an example VGA controller 245, an example DC compensator 246, an example amplitude moving average filter 810 and an example offset moving average filter 820. Calculator 244 may output the amplitude (damp) signal to amplitude moving average filter 810 and VGA controller 245. Calculator 244 may output offset (doffset) to moving average filter 820 and DC compensator 246.

The amplitude moving average filter 810 is a specialized electronic circuit designed to process and smooth the amplitude (damp) signal. This smoothing operation is achieved by calculating the average of a predetermined number of recent amplitude samples within a defined time frame, known as a sliding window. As new samples are received, the window "slides" forward in time, maintaining a consistent number of samples for averaging. This technique effectively reduces short-term fluctuations and noise in the amplitude signal, providing a more stable representation of the overall signal trend.

VGA controller 245 may comprise several interconnected components: filter 841, integrator 842, hysteresis comparator 843, memory 844, and locking circuit 845. Each of these components may play a specific role in processing and controlling the variable gain amplification. The VGA controller 245 may receive the amplitude (damp) signal from calculator 244, which may serve as a basis for gain adjustments. The VGA controller 245 may process the amplitude (damp) signal through its components to make gain adjustment decisions. This adaptive mechanism may help the variable gain amplifier 222 maintain appropriate amplification levels for incoming analog inputs across varying input conditions in mixed-signal system 100.

Filter 841 within the VGA controller 245 may perform additional signal conditioning on the amplitude (damp) signal. The integrator 842 may accumulate the weighted amplitude signal over time, providing a measure of the weighted amplitude signal signal's overall energy or average level. The hysteresis comparator 843 may compare the integrated amplitude signal against a predefined threshold, introducing a level of stability to prevent rapid oscillations in the gain code. Memory 844 may store previous gain settings or threshold values, allowing for adaptive behavior based on historical data. The locking circuit 845 may be responsible for maintaining stable gain settings once an optimal level is reached, potentially preventing unnecessary adjustments due to minor signal fluctuations.

Filter 841, a key component of the VGA controller 245, may transform the amplitude (damp) signal into a weighted amplitude signal. Filter 841 receives inputs from multiple sources: the amplitude (damp) signal from calculator 244, the moving average amplitude from amplitude moving average filter 810, an amplitude setpoint from register 243, and an amplitude scale factor from register 243. Filter 841 may compare the amplitude (damp) signal with the amplitude setpoint, which serves as a predetermined reference point. This comparison yields a result with two distinct states: one where the amplitude (damp) signal is less than the setpoint, and another where it is greater than or equal to the setpoint. The amplitude scale factor, a constant value, determines the multiplication factor applied to this comparison result. The filter then converts this multiplied result into a weighted amplitude signal.

Integrator 842 is an electronic circuit that may continuously average the weighted amplitude signal over a defined period, smoothing short-term fluctuations and minimizing rapid changes in the weighted amplitude signal. Integrator 842 may receive VGA gain from register 243. VGA gain may be an adjustable scaling factor that controls the accumulation rate of the weighted amplitude signal by integrator 842.

Hysteresis comparator 843 may operate as an electronic circuit configured to convert the averaged amplitude signal from integrator 842 into a bistable amplitude signal by comparing the averaged amplitude to a gain threshold. A threshold point may be characterized as a predefined voltage or signal level at which hysteresis comparator 843 may transition the output state, with distinct upper and lower thresholds determined by the hysteresis band. The hysteresis band may represent a defined range of values surrounding the threshold point, establishing separate switching thresholds to regulate state transitions. When the averaged amplitude signal surpasses the gain threshold, hysteresis comparator 843 may adjust the bistable amplitude to a high state. Hysteresis comparator 843 may adjust the bistable amplitude to a low state in response to a decrease in the signal below the threshold by an amount equivalent to the hysteresis band.

To maintain system responsiveness to analog input changes in the weighted amplitude signal, the hysteresis comparator 843 may trigger a reset signal to integrator 842 when the bistable amplitude changes state. This reset may allow integrator 842 to adapt to new input conditions for the weighted amplitude signal.

Memory 844 may serve as the final stage in this process, receiving and storing the bistable amplitude signal. This stored information can be used to inform future gain adjustment decisions or to track the history of amplitude variations over time, potentially providing a basis for long-term adaptive behavior in the VGA controller 245. Memory 844 may output the bistable amplitude signal in the form of a gain code.

Analog signal processor 220 may receive the gain code from VGA controller 245, as illustrated in FIG. 2. The gain code is a gain control signal for variable gain amplifier 222. Variable gain amplifier 222 may process the gain code to set an amplification factor (x) that scales the amplitude ((x)V) of the analog input as illustrated in the example of FIGS. 6A-6E. As an example, current-to-voltage converter 221 may convert an input current corresponding to the analog input into a proportional voltage. As the voltage from current-to-voltage converter 221 passes through variable gain amplifier 222, variable gain amplifier 222 may scale the amplitude of the voltage according to the amplification factor (x), resulting in an amplified voltage. An adjustment in the value of the gain code may dynamically adjust the amplification factor (x) in precise, repeatable, and programmable steps.

In some implementations, variable gain amplifier 222 may be a differential amplifier along with driver 223 being a differential driver. Driver 223 may receive the amplified voltage from variable gain amplifier 222 and output non-inverted signal (Va) and inverted signal (Vb). Binary words d(Pa), d(Pb), d(Va) and d(Vb) represent the peaks and two valleys for non-inverted signal (Va) and inverted signal (Vb).

Driver 223 may isolate variable gain amplifier 222 from sampler circuit 210 to prevent any loading effects onto variable gain amplifier 222 that may happen to be from sampler circuit 210.

Offset moving average filter 820 is designed to smooth offset (doffset) by averaging a fixed number of past samples of offset (doffset) within a sliding window. DC compensator 246 may receive the smoothed offset (doffset) from offset moving average filter 820 in the form of a moving average offset.

DC compensator 246 may comprise several interconnected components: filter 861, integrator 862, hysteresis comparator 863, memory 864, and locking circuit 865. Each of these components may play a specific role in processing and correcting the analog input. The DC compensator 246 may receive the offset (doffset) signal from calculator 244, which may serve as a basis for offset adjustments. The DC compensator 246 may process the offset (doffset) signal through its components to make offset adjustment decisions. This adaptive mechanism may help the DC correction generator 230 maintain appropriate correction levels for incoming analog inputs across varying input conditions in mixed-signal system 100.

Filter 861 within the DC compensator 246 may perform additional signal conditioning on the offset (doffset) signal. The integrator 862 may accumulate the weighted offset signal over time, providing a measure of the weighted offset signal signal's overall energy or average level. The hysteresis comparator 863 may compare the integrated offset signal against a predefined threshold, introducing a level of stability to prevent rapid oscillations in the correction code. Memory 864 may store previous gain settings or threshold values, allowing for adaptive behavior based on historical data. The locking circuit 865 may be responsible for maintaining stable gain settings once an optimal level is reached, potentially preventing unnecessary adjustments due to minor signal fluctuations.

Filter 861, a key component of the DC correction generator 230, may transform the offset (doffset) signal into a weighted offset signal. Filter 861 receives inputs from multiple sources: the offset (doffset) signal from calculator 244, the moving average offset from offset moving average filter 820, an offset setpoint from register 243, and an offset scale factor from register 243. Filter 861 may compare the offset (doffset) signal with the offset setpoint, which serves as a predetermined reference point. This comparison yields a result with two distinct states: one where the offset (doffset) signal is less than the setpoint, and another where it is greater than or equal to the setpoint. The offset scale factor, a constant value, determines the multiplication factor applied to this comparison result. The filter then converts this multiplied result into a weighted offset signal.

Integrator 862 is an electronic circuit that may continuously average the weighted offset signal over a defined period, smoothing short-term fluctuations and minimizing rapid changes in the weighted offset signal. Integrator 862 may receive offset gain from register 243. Offset gain may be an adjustable scaling factor that controls the accumulation rate of the weighted offset signal by integrator 862.

Hysteresis comparator 863 may operate as an electronic circuit configured to convert the averaged offset signal from integrator 862 into a bistable offset signal by comparing the averaged offset to a gain threshold. A threshold point may be characterized as a predefined voltage or signal level at which hysteresis comparator 863 may transition the output state, with distinct upper and lower thresholds determined by the hysteresis band. The hysteresis band may represent a defined range of values surrounding the threshold point, establishing separate switching thresholds to regulate state transitions. When the averaged offset signal surpasses the gain threshold, hysteresis comparator 863 may adjust the bistable offset to a high state. Hysteresis comparator 863 may adjust the bistable offset to a low state in response to a decrease in the signal below the threshold by an amount equivalent to the hysteresis band.

To maintain system responsiveness to analog input changes in the weighted offset signal, the hysteresis comparator 863 may trigger a reset signal to integrator 862 when the bistable offset changes state. This reset may allow integrator 862 to adapt to new input conditions for the weighted offset signal.

Memory 864 may serve as the final stage in this process, receiving and storing the bistable offset signal. This stored information can be used to inform future gain adjustment decisions or to track the history of offset variations over time, potentially providing a basis for long-term adaptive behavior in the DC correction generator 230. Memory 864 may output the bistable offset signal in the form of a correction code.

DC compensator 246 may include filter 861, integrator 862, hysteresis comparator 863 and memory 864. Filter 861 is an electronic circuit that may apply the moving average offset from offset moving average filter 820 and a desired offset from register 243 to filter the offset from calculator 244. Integrator 862 is an electronic circuit that may continuously average the filtered offset from filter 861 to reduce fluctuations in the filtered offset. Hysteresis comparator 863 is an electronic circuit that may convert the integrated offset from integrator 862 into a bistable offset signal and feed the bistable offset signal to memory 864. Memory 864 may output the bistable offset signal in the form of a correction code.

DC correction generator 230 may receive the correction code from DC compensator 246, as illustrated in FIG. 2. Referred to herein, a "baseline" of a signal is the natural resting state or expected reference level of the signal in the absence of relevant information in the signal. In contrast to the baseline, an "offset" is an unwanted and/or undesired deviation from the baseline that can distort accuracy of the analog input. DC correction generator 230 may convert the correction code into an analog correction signal and output the correction signal to analog signal source 110. The correction signal may introduce, into the signal input, an equal and opposite signal that eliminates or reduces the offset.

The arrangement or interconnection of components, as indicated by terms such as "coupled," "connected," "on," or "under," may allow for indirect connections or the presence of intervening components or layers. In contrast, terms such as "electrically connected directly," "electrically directly connected," and "directly electrically connected" refer specifically to connections along a conductive path without any intermediary component.

Certain operations of methods described in this technology, or systems executing those methods, may be schematically represented in figures or textual descriptions. Unless explicitly stated, the spatial arrangement of operations in figures does not necessarily dictate the sequence in which they must be performed. Operations may be executed in a different order than illustrated, depending on implementation requirements. Additionally, certain operations may be performed in parallel or partially in parallel, utilizing dedicated parallel processing devices or separate computing systems that interoperate within a larger system.

The term "or," unless otherwise defined or limited, denotes a non-exclusive list, allowing various combinations of listed elements rather than restricting them to mutually exclusive alternatives. For example, a list including "A, B, or C" may encompass A alone, B alone, C alone, any combination of two elements, or all three elements together. Exclusivity applies only when expressly stated using terms such as "either," "only one of," or "exactly one of." Similarly, lists preceded by phrases such as "one or more of" or "at least one of" indicate the possibility of multiple occurrences of any or all listed elements. A list introduced by "a plurality of" or "two or more of" suggests multiple instances of any or all elements. The term "or" should only be interpreted as exclusive when explicitly specified by contextual qualifiers.

The articles "a," "an," and "the" generally encompass both singular and plural forms unless explicitly stated otherwise. The terms "comprises," "includes," and "has" indicate the presence of stated features, components, operations, or elements while not excluding additional features, components, or combinations thereof.

Throughout this document, ordinal numbers such as "first," "second," and "third" may be used to describe various elements. These terms serve solely to distinguish elements from one another rather than imply a specific sequence, hierarchy, or limitation on quantity. Ordinal numbers do not necessarily dictate an order unless explicitly modified by terms such as "before," "after," or "single." A first element is distinct from a second element, and the first element may contain multiple components or appear before or after the second element in a given arrangement. The designation of ordinal numbers may be interchangeable without altering the scope of the described examples.

Any trademarks referenced herein may be common law or registered trademarks of third parties affiliated or unaffiliated with the applicant or assignee. These references are provided for illustrative purposes only and should not be interpreted as limiting the disclosed embodiments to material associated exclusively with those trademarks.

## Claims

1. An apparatus comprising:
a sampler circuit configured to:
convert, in response to receiving a first code, the first code into a reference signal and
produce, in response to comparing an input signal to the reference signal, a bitstream; and
a tracking filter configured to:
update, upon receiving the bitstream from the sampler circuit, the first code using information contained in the bitstream, and
output, in response to updating the first code, the first code to the sampler circuit.

2. The apparatus according to claim 1, wherein
the first code is a DAC code.

3. The apparatus according to claim 1 or 2, further comprising:
a calculator configured to calculate, in response to the tracking filter updating the first code, a value for a second code and a value for a third code.

4. The apparatus according to claim 3, wherein
the second code is a correction code;
and/or
the third code is a gain code.

5. The apparatus according to any one of the claims 1 to 4, further comprising:
a timing circuit configured to provide, to the sampler circuit during production of the bitstream, a clock signal that causes the sampler circuit to sample the input signal at a rate below the Nyquist rate.

6. The apparatus according to any one of the claims 1 to 5, wherein
the first code represents discrete amplitude value of a peak envelope for the input signal.

7. The apparatus according to any one of the claims 1 to 6, wherein
the first code represents discrete amplitude value of a valley envelope for the input signal.

8. The apparatus according to any one of the claims 1 to 7, wherein
the reference signal is an analog signal.

9. The apparatus according to any one of the claims 1 to 8, wherein
the first code comprises a fixed number of bits.

10. The apparatus according to any one of the claims 1 to 9, wherein
the bitstream is a stream of binary values.

11. The apparatus according to any one of the claims 1 to 10, wherein
the tracking filter is configured to extract, in response to converting the bitstream into the first code, information from the bitstream indicating whether the input signal exceeds or falls below the reference signal.

12. The apparatus according to any one of the claims 1 to 11, wherein
the sampler circuit comprises:
a multiplexer configured to output, as the input signal in response to selecting between a non-inverted signal and an inverted signal, the non-inverted signal or the inverted signal;
wherein in particular
the non-inverted signal and the inverted signal are a differential output pair of signals.

13. The apparatus according to claim 11 or 12, wherein
the non-inverted signal is 180 degrees out of phase with the inverted signal;
and/or wherein
the multiplexer is configured to alternate, in response to a transition of a comparator clock, between the non-inverted and inverted signals.

14. A method comprising:
converting, by a sampler circuit, a first code into a reference signal in response to receiving the first code;
producing, by the sampler circuit, a bitstream in response to comparing an input signal to the reference signal;
updating, by a tracking filter upon receiving the bitstream from the sampler circuit, the first code using information contained in the bitstream; and
outputting, by the tracking filter in response to updating the first code, the first code to the sampler circuit.

15. The method according to claim 14, further comprising:
selecting between a non-inverted signal and an inverted signal by a multiplexer in the sampler circuit:
wherein in particular
The method further comprises:
outputting, by the multiplexer, the non-inverted signal or the inverted signal in response to selecting between the non-inverted signal and the inverted signal.
